# EUROPEAN PATENT APPLICATION

(11) **EP 3 742 484 A1**
(43) Date of publication of application: **25.11.2020**
(21) Application number: 20175607.9
(22) Date of filing: 20.05.2020
(51) Int. Cl.: H01L 25/075, H01L 33/54, H01L 33/62, H01L 33/48

(54) **ELECTRONIC DEVICE AND LIGHT-EMITTING ELEMENT**

(30) Priority: 23.05.2019 US 201962851654 P; 14.02.2020 CN 202010093294
(71) Applicant: InnoLux Corporation, Chu-Nan, Miao-Li County 35053 (TW)
(72) Inventor: YAN, Tzu-Min, 35053 Chu-Nan, Miao-Li County (TW); HSIEH, Tsau-Hua, 35053 Chu-Nan, Miao-Li County (TW)
(74) Representative: Emde, Eric

(57) **Abstract**

The disclosure provides an electronic device and a light-emitting element. The electronic device includes a substrate and at least one light-emitting element. The at least one light-emitting element is disposed on the substrate. The at least one light-emitting element includes a first light-emitting diode, a second light-emitting diode, an organic layer, and a conductive layer. The organic layer is disposed between the first light-emitting diode and the conductive layer. The organic layer includes at least two through holes. The conductive layer is electrically connected to the first light-emitting diode and the second light-emitting diode through the at least two through holes.

## Description

### BACKGROUND

### Technical field

The disclosure relates to an electronic device and a light-emitting element, and in particular, to an electronic device, one light-emitting element thereof having a plurality of light-emitting diodes.

### Description of Related Art

With the rapid development of electronic products, display technologies applied to electronic products have also been continuously improved. Electronic devices for display are being developed to pursue greater display effects with a higher resolution.

### SUMMARY

The disclosure provides an electronic device and a light-emitting element with relatively low power consumption.

According to an embodiment of the disclosure, the electronic device includes a substrate and at least one light-emitting element. The at least one light-emitting element is disposed on the substrate. The at least one light-emitting element includes a first light-emitting diode, a second light-emitting diode, an organic layer, and a conductive layer. The organic layer is disposed between the first light-emitting diode and the conductive layer. The organic layer includes at least two through holes. The conductive layer is electrically connected to the first light-emitting diode and the second light-emitting diode through the at least two through holes.

Based on the above, in the electronic device according to the embodiments of the disclosure, the light-emitting element includes two or more light-emitting diodes (the first light-emitting diode and the second light-emitting diode). In addition, the organic layer may be disposed between the conductive layer and the light-emitting diode to reduce the probability of disconnection of the conductive layer, and the light-emitting diodes may be fixed together and surrounded by the organic layer and electrically connected by the conductive layer. Accordingly, the electronic device including the light-emitting element may have relatively low power consumption.

### BRIEF DESCRIPTION OF THE DRAWINGS

The accompanying drawings are included to provide a further understanding of the disclosure, and the accompanying drawings are incorporated in and constitute a part of this specification. The accompanying drawings illustrate embodiments of the disclosure and, together with the description, serve to explain the principles of the disclosure.
FIG. 1A is a schematic cross-sectional view of an electronic device according to a first embodiment of the disclosure.
FIG. 1B is an enlarged schematic view of a light-emitting element in the electronic device of FIG. 1A.
FIG. 2 is a schematic cross-sectional view of a light-emitting element according to a second embodiment of the disclosure.
FIG. 3 is a schematic cross-sectional view of a light-emitting element according to a third embodiment of the disclosure.
FIG. 4 is a schematic cross-sectional view of a light-emitting element according to a fourth embodiment of the disclosure.
FIG. 5 is a schematic cross-sectional view of a light-emitting element according to a fifth embodiment of the disclosure.
FIG. 6A is a schematic cross-sectional view of an electronic device according to a sixth embodiment of the disclosure.
FIG. 6B is an enlarged schematic view of a light-emitting element in the electronic device of FIG. 6A.

### DESCRIPTION OF THE EMBODIMENTS

This disclosure may be understood with reference to the following detailed description and the accompanying drawings. It should be noted that, for ease of understanding by readers and concise drawings, a plurality of drawings in this disclosure merely show a part of an electronic device, and specific components in the drawings are not drawn to scale. In addition, the quantity and size of the components in the drawings are merely exemplary, and are not intended to limit the scope of this disclosure.

A structure (or layer, component, substrate) being located on another structure (or layer, component, substrate) described in the disclosure may mean that two structures are adjacent and directly connected, or may mean that two structures are adjacent and indirectly connected. Indirect connection means that there is at least one intermediate structure (or intermediate layer, intermediate component, intermediate substrate, or intermediate spacing) between two structures, the lower surface of a structure is adjacent or directly connected to the upper surface of the intermediate structure, and the upper surface of the other structure is adjacent or directly connected to the lower surface of the intermediate structure. The intermediate structure may be a single-layer or multi-layer physical structure or non-physical structure, which is not limited. In the disclosure, when a structure is disposed "on" another structure, it may mean that a structure is "directly" disposed on another structure, or a structure is "indirectly" disposed on another structure, that is, at least one structure is sandwiched between a structure and another structure.

The electrical connection or coupling described in the disclosure may refer to direct connection or indirect connection. In the case of a direct connection, terminals of two components on a circuit are directly connected or interconnected by a conductor segment. In the case of an indirect connection, there are switches, diodes, capacitors, inductors, resistors, other suitable components, or a combination of the above components between terminals of two components on a circuit, but are not limited thereto.

In the disclosure, the length and width may be measured by an optical microscope, and the thickness may be measured by a cross-sectional image in an electron microscope, but is not limited thereto. In addition, there may be some error between any two values or directions used for comparison.

Although the terms first, second, third and the like may be used for describing various constituent elements, the constituent elements are not limited by the terms. The terms are only used to distinguish a single constituent element from other constituent elements in the specification. The same terms may not be used in the claims, but may be replaced by first, second, third, and the like in the order of element declarations in the claims. Therefore, in the following specification, a first constituent element may be a second constituent element in a claim.

The electronic device in the disclosure may include a display device, an antenna device, a sensing device, a touch display, a curved display, or a free shape display, but is not limited thereto. The electronic device may be a bendable or flexible electronic device. The electronic device may include, for example, a light emitting diode, a liquid crystal, a fluorescence, a phosphor, other suitable display media, or a combination thereof, but is not limited thereto. The light emitting diode may include, for example, an organic light emitting diode (OLED), an inorganic light emitting diode (LED), a sub-millimeter light emitting diode (mini LED), and a micro light emitting diode (micro LED), or a quantum dot light emitting diode (quantum dot, QD, for example, QLED or QDLED), or other suitable materials or any combination of the above-mentioned arrangements, but is not limited thereto. The display device may include, for example, a splicing display device, but is not limited thereto. The antenna device may be, for example, a liquid crystal antenna, but is not limited thereto. The antenna device may include, for example, an antenna splicing device, but is not limited thereto. It should be noted that the electronic device may be any combination of the aforementioned arrangements, but is not limited thereto. In addition, the appearance of the electronic device may be rectangular, circular, polygonal, a shape with curved edges, or other suitable shapes. The electronic device may have peripheral systems such as a driving system, a control system, a light source system, and a shelf system, to support a display device, an antenna device, or a splicing device. The disclosure will be described in the following with an electronic device, but the disclosure is not limited thereto.

It should be noted that the following embodiments may replace, recombine, and mix features of different embodiments to complete other embodiments without departing from the spirit of the disclosure. The features of the embodiments may be used in any combination without departing from the spirit of the disclosure or conflicting with each other.

Reference may now be made in detail to the exemplary embodiments of the disclosure, examples of which are illustrated in the accompanying drawings. Whenever possible, the same element symbols are used in the drawings and descriptions to indicate the same or similar parts.

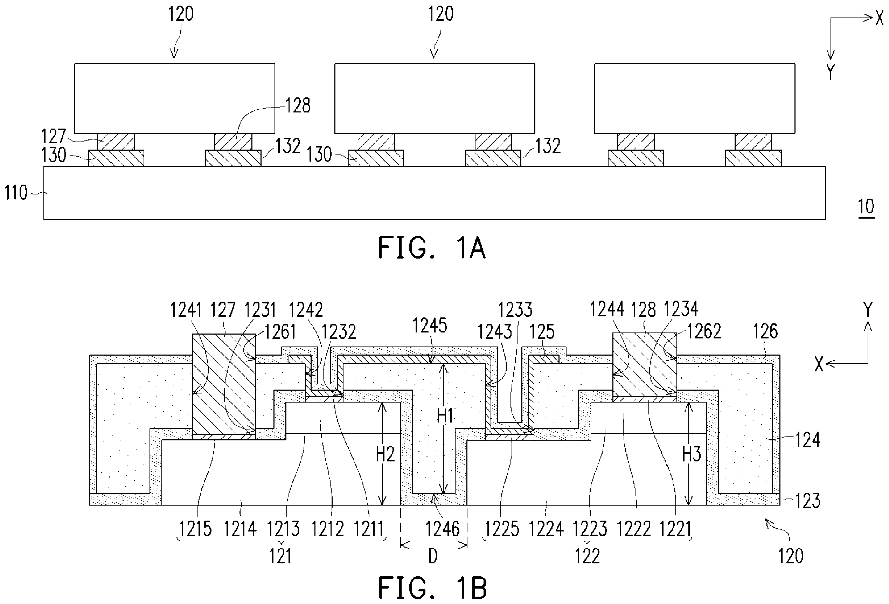

FIG. 1A is a schematic cross-sectional view of an electronic device according to a first embodiment of the disclosure. In order to make the drawings clear and for ease of description, several elements in a light-emitting element 120 are omitted in FIG. 1A. FIG. 1B is an enlarged schematic view of a light-emitting element in the electronic device of FIG. 1A. For ease of description, FIG. 1B is shown by turning the light-emitting element 120 in FIG. 1A upside down to indicate a state that the light-emitting element 120 is disposed on a growth substrate (not shown). Referring to FIG. 1A and FIG. 1B together, an electronic device 10 of the present embodiment includes a substrate 110, at least one light-emitting element 120 (three light-emitting elements 120 are schematically shown in FIG. 1A), at least one first pad 130, and at least one second pad 132. The first pad 130 and the second pad 132 are respectively disposed on the substrate 110, and the light-emitting element 120 is disposed on the first pad 130 and the second pad 132. In the present embodiment, the substrate 110 may further include a wiring layer and an active element (not shown), to be electrically connected to the first pad 130 or the second pad 132 on the substrate 110. The wiring layer may include, but is not limited to, a scanning line, a data line, a power supply line, a common voltage line, a signal reference line, and a touch signal line. The active element may include, but is not limited to, a thin-film transistor (TFT). The substrate 110 may be, for example, a flexible substrate, a rigid substrate, or a combination thereof. For example, the substrate 110 may be made of metal, plastic, glass, quartz, sapphire, ceramic, polycarbonate (PC), polyimide (PI), and polyethylene terephthalate (PET), glass fiber, ceramics, other suitable substrate materials, or a combination of the foregoing, but this is not limited thereto. In the present embodiment, the first pad 130 and the second pad 132 may be made of, for example, silver, copper, aluminium, molybdenum, tungsten, gold, chromium, nickel, platinum, titanium, iridium, rhodium, indium, bismuth, an alloy of the foregoing, a combination of the foregoing, or other metal materials with good conductivity, but this is not limited thereto. In some embodiments, the first pad 130 and the second pad 132 may be made of a same material or different materials.

In the present embodiment, the light-emitting element 120 is disposed on the substrate 110, and the light-emitting element 120 is electrically connected to the wiring layer or the active element on the substrate 110 through the first pad 130 and the second pad 132. In the present embodiment, a size (for example, a maximum size in a direction X) of the light-emitting element 120 may be less than 100 micrometers. In some embodiments, a size (for example, a maximum size in a direction X) of the light-emitting element 120 may range from 20 micrometers to 30 micrometers. A direction X and a direction Y are marked in FIG. 1A. The direction Y may be a normal direction of an upper surface of the substrate 110, and the direction X is perpendicular to the direction Y and parallel to the upper surface of the substrate 110. The following embodiments may be described according to the direction X and the direction Y in the subsequent drawings. The light-emitting element 120 includes a first light-emitting diode 121, a second light-emitting diode 122, a first insulation layer 123, an organic layer 124, a conductive layer 125, and a second insulation layer 126. The second light-emitting diode 122 is disposed adjacent to the first light-emitting diode 121. A minimum spacing D between the first light-emitting diode 121 and the second light-emitting diode 122 may range from 1.5 µm to 10 µm, but this is not limited thereto. In some embodiments, the minimum spacing D between the first light-emitting diode 121 and the second light-emitting diode 122 may range from 1.5 µm to 3 µm.

Specifically, in the present embodiment, the first light-emitting diode 121 and the second light-emitting diode 122 may be miniature light-emitting diodes, but this is not limited thereto. In the present embodiment, the first light-emitting diode 121 and the second light-emitting diode 122 may each include two electrodes of different polarities. A p-type electrode and an n-type electrode are used as examples in the following embodiment, but this is not limited thereto. The first light-emitting diode 121 includes a first p-type electrode 1211, a first p-type semiconductor layer 1212, a light-emitting layer 1213, a first n-type semiconductor layer 1214, and a first n-type electrode 1215. The light-emitting layer 1213 is located between the first p-type semiconductor layer 1212 and the first n-type semiconductor layer 1214. The first p-type electrode 1211 is disposed on the first p-type semiconductor layer 1212, and the first p-type electrode 1211 is electrically connected to the first p-type semiconductor layer 1212. The first n-type electrode 1215 is disposed on the first n-type semiconductor layer 1214, and the first n-type electrode 1215 is electrically connected to the first n-type semiconductor layer 1214. In the present embodiment, the first p-type semiconductor layer 1212 is made of, for example, P-type doped GaN, InN, AlN, InₓGa₍₁₋ₓ₎N, AlxIn₍₁₋ₓ₎N, AlₓIn_{y}Ga_{(1-x-y)}N or other materials, where 0 ≤ x ≤ 1, 0 ≤ y ≤ 1, and 0 ≤ (x + y) ≤ 1. The first n-type semiconductor layer 1214 is made of, for example, n-type doped GaN, InN, AlN, InₓGa₍₁₋ₓ₎N, AlₓIn₍₁₋ₓ₎N, AlₓIn_{y}Ga_{(1-x-y)}N or other materials, where 0 ≤ x ≤ 1, 0 ≤ y ≤ 1, and 0 ≤ (x + y) ≤ 1, but this is not limited thereto. The light-emitting element 120 may be a flip-chip type light-emitting element. In other words, the electrode (for example, the first p-type electrode 1211 and the first n-type electrode 1215) of the light-emitting element 120 and the light-emitting layer 1213 are disposed on a same side of the light-emitting element 120, but the type of the light-emitting element is not limited thereto.

Then the second light-emitting diode 122 includes a second p-type electrode 1221, a second p-type semiconductor layer 1222, a light-emitting layer 1223, a second n-type semiconductor layer 1224, and a second n-type electrode 1225. The light-emitting layer 1223 is located between the second p-type semiconductor layer 1222 and the second n-type semiconductor layer 1224. The second p-type electrode 1221 is disposed on the second p-type semiconductor layer 1222, and the second p-type electrode 1221 is electrically connected to the second p-type semiconductor layer 1222. The second n-type electrode 1225 is disposed on the second n-type semiconductor layer 1224, and the second n-type electrode 1225 is electrically connected to the second n-type semiconductor layer 1224. In the present embodiment, the second p-type semiconductor layer 1222 is made of, for example, P-type doped GaN, InN, AlN, InxGa₍₁₋ₓ₎N, AlₓIn₍₁₋ₓ₎N, AlₓIn_{y}Ga_{(1-x-y)}N or other materials, where 0 ≤ x ≤ 1, 0 ≤ y ≤ 1, and 0 ≤ (x + y) ≤ 1. The second n-type semiconductor layer 1224 is made of, for example, n-type doped GaN, InN, AlN, InₓGa₍₁₋ₓ₎N, AlₓIn₍₁₋ₓ₎N, AlₓIn_{y}Ga_{(1-x-y)}N or other materials, where 0 ≤ x ≤ 1, 0 ≤ y ≤ 1, and 0 ≤ (x + y) ≤ 1, but this is not limited thereto.

The first insulation layer 123 is disposed on the first light-emitting diode 121 and the second light-emitting diode 122. The first insulation layer 123 at least partially covers and/or surrounds the first light-emitting diode 121 and the second light-emitting diode 122. The first insulation layer 123 includes an opening 1231, an opening 1232, an opening 1233, and an opening 1234. The opening 1231 exposes the first n-type electrode 1215 of a portion of the first light-emitting diode 121, and the opening 1232 exposes the first p-type electrode 1211 of a portion of the first light-emitting diode 121. The opening 1233 exposes the second n-type electrode 1225 of a portion of the second light-emitting diode 122, and the opening 1234 exposes the second p-type electrode 1221 of a portion of the second light-emitting diode 122. In the present embodiment, the first insulation layer 123 may be made of silicon oxide, silicon nitride, silicon oxynitride, or a combination thereof, but this is not limited thereto.

The organic layer 124 is disposed on the first insulation layer 123. The organic layer 124 at least partially covers the first insulation layer 123 and/or selectively surrounds the first light-emitting diode 121 and the second light-emitting diode 122. The organic layer 124 includes at least two through holes 1241, 1242, 1243, and 1244. The through hole 1241 is in cooperation with the opening 1231 of the first insulation layer 123, to expose the first n-type electrode 1215 of the portion of the first light-emitting diode 121. The through hole 1242 is in cooperation with the opening 1232 of the first insulation layer 123, to expose the first p-type electrode 1211 of the portion of the first light-emitting diode 121. The through hole 1243 is in cooperation with the opening 1233 of the first insulation layer 123, to expose the second n-type electrode 1225 of the portion of the second light-emitting diode 122. The through hole 1244 is in cooperation with the opening 1234 of the first insulation layer 123, to expose the second p-type electrode 1221 of the portion of the second light-emitting diode 122. In the present embodiment, the organic layer 124 is disposed between the first light-emitting diode 121 and the second light-emitting diode 122, and is disposed between the first light-emitting diode 121 and the conductive layer 125, and is disposed between the second light-emitting diode 122 and the conductive layer 125. The organic layer 124 may be made of, for example, acrylic, siloxane, polyimide resin, a combination of the foregoing materials, or other suitable organic materials, but this is not limited thereto. In some embodiments, the organic layer 124 may be a multilayer structure.

In addition, the organic layer 124 has a first surface 1245 and a second surface 1246 opposite to each other, the first surface 1245 being away from the first light-emitting diode 121 and the second light-emitting diode 122. A maximum thickness H1 of the organic layer 124 may be regarded as a maximum distance (for example, a maximum distance between the first surface 1245 and the second surface 1246 along the direction Y) between the first surface 1245 and the second surface 1246 of the organic layer 124. In the present embodiment, since the maximum thickness H1 of the organic layer 124 is greater than a maximum height H2 (for example, a maximum height along the direction Y) of the first light-emitting diode 121 and a maximum height H3 (for example, a maximum height along the direction Y) of the second light-emitting diode 122, so that when a growth substrate (not shown) is irradiated using a laser to separate the growth substrate (not shown) from the light-emitting element 120, a probability of breakage may be reduced when the conductive layer 125 is disposed on the organic layer 124. In the present embodiment, before the laser is used to separate the growth substrate (not shown) from the light-emitting element 120, the light-emitting element 120 is disposed on the growth substrate (not shown), and the first light-emitting diode 121 and the second light-emitting diode 122 of the light-emitting element 120 are in contact with the growth substrate (not shown), respectively. In the present embodiment, in a normal direction (for example, the direction Y), the maximum thickness H1 of the organic layer 124 may range from 3 µm to 10 µm, the maximum height H2 of the first light-emitting diode 121 and the maximum height H3 of the second light-emitting diode 122 may range from 4 micrometers to 6 micrometers, but is not limited thereto.

The conductive layer 125 is disposed on a portion of the organic layer 124 and inside at least two through holes 1242 and 1243. Specifically, the conductive layer 125 is disposed on the through hole 1242 and on a side wall and a bottom of the through hole 1243, and is disposed on the organic layer 124 between the through hole 1242 and the through hole 1243. The conductive layer 125 may be electrically connected to the first light-emitting diode 121 and the second light-emitting diode 122 through the through hole 1242 and the through hole 1243. In the present embodiment, the conductive layer 125 is in contact with the first p-type electrode 1211 and the second n-type electrode 1225. In other words, the conductive layer 125 is electrically connected to the first p-type electrode 1211 of the first light-emitting diode 121 and the second n-type electrode 1225 of the second light-emitting diode 122. That is, the first light-emitting diode 121 may be electrically connected to the second light-emitting diode 122 through the conductive layer 125. In the present embodiment, the first light-emitting diode 121 and the second light-emitting diode 122 may be electrically connected in series, but this is not limited thereto. In other embodiments, the first light-emitting diode and the second light-emitting diode may also be electrically connected in parallel.

The second insulation layer 126 is disposed on the organic layer 124 and the conductive layer 125. The second insulation layer 126 at least partially covers the organic layer 124 and the conductive layer 125. The second insulation layer 126 includes an opening 1261 and an opening 1262. The opening 1261 is in cooperation with the through hole 1241 of the organic layer 124 and the opening 1231 of the first insulation layer 123, to expose the first n-type electrode 1215 of the portion of the first light-emitting diode 121. The opening 1262 is in cooperation with the through hole 1244 of the organic layer 124 and the opening 1234 of the first insulation layer 123, to expose the second p-type electrode 1221 of the portion of the second light-emitting diode 122. In the present embodiment, the second insulation layer 126 may be made of silicon oxide, silicon nitride, silicon oxynitride, or a combination thereof, but this is not limited thereto.

In the present embodiment, the light-emitting element 120 further includes a first conductive pad 127 and a second conductive pad 128. The first conductive pad 127 is disposed on the first light-emitting diode 121, and the second conductive pad 128 is disposed on the second light-emitting diode 122. Specifically, the first conductive pad 127 is disposed in the opening 1231 of the first insulation layer 123, the through hole 1241 of the organic layer 124, and the opening 1261 of the second insulation layer 126, and is exposed outside the second insulation layer 126. That is, the first conductive pad 127 is disposed on the first n-type electrode 1215 of the first light-emitting diode 121, and the first conductive pad 127 is electrically connected to the first n-type electrode 1215. The second conductive pad 128 is disposed in the opening 1234 of the first insulation layer 123, the through hole 1244 of the organic layer 124, and the opening 1262 of the second insulation layer 126, and is exposed outside the second insulation layer 126. That is, the second conductive pad 128 is disposed on the second p-type electrode 1221 of the second light-emitting diode 122, and the second conductive pad 128 is electrically connected to the second p-type electrode 1221. In the present embodiment, the conductive layer 125 is located between the first conductive pad 127 and the second conductive pad 128, and the conductive layer 125 is not in contact with and/or is electrically insulated from the first conductive pad 127 and the second conductive pad 128. In the present embodiment, the first conductive pad 127 and the second conductive pad 128 may be made of silver, copper, aluminium, molybdenum, tungsten, gold, chromium, nickel, platinum, titanium, iridium, rhodium, indium, bismuth, an alloy of the foregoing, a combination of the foregoing, or other metal materials with good conductivity, but this is not limited thereto.

More specifically, in the present embodiment, the first n-type electrode 1215 may be electrically connected to the first pad 130 through the first conductive pad 127, and the second p-type electrode 1221 may be electrically connected to the second pad 132 through the second conductive pad 128. That is, the first pad 130 may be electrically connected to the first n-type electrode 1215 of the first light-emitting diode 121, and the second pad 132 may be electrically connected to the second p-type electrode 1221 of the second light-emitting diode 122.

It may be learned based on the foregoing that, the light-emitting element 120 in the electronic device 10 of the present embodiment may include two light-emitting diodes (a first light-emitting diode 121 and a second light-emitting diode 122). Next, the first light-emitting diode 121 and the second light-emitting diode 122 may be fixed together by using the organic layer 124, and the first light-emitting diode 121 and the second light-emitting diode 122 may be electrically connected by using the conductive layer 125, so that the electronic device 10 including the light-emitting element 120 may have relatively low power consumption.

In addition, although the light-emitting element 120 of the present embodiment includes two light-emitting diodes, the quantity of light-emitting diodes in the light-emitting element is not limited in the disclosure. In other words, in other embodiments, the light-emitting element may alternatively include more than two light-emitting diodes. In some embodiments, the light-emitting element may include two to ten light-emitting diodes.

In the foregoing embodiment, the light-emitting element 120 includes a plurality of light-emitting diodes (for example, including the first light-emitting diode 121 and the second light-emitting diode 122), and the light-emitting element 120 may include two or more conductive pads. In some embodiments, the light-emitting element 120 may need only two conductive pads that are respectively bonded to the first pad 130 and the second pad 132, that is, the first conductive pad 127 and the second conductive pad 128, to drive the plurality of light-emitting diodes (for example, including the first light-emitting diode 121 and the second light-emitting diode 122) in the light-emitting element 120. In other words, each light-emitting element 120 may be bonded to one first pad 130 and one second pad 132. It should be understood that the drawings of the foregoing embodiments are merely examples, and the light-emitting elements of other embodiments may include more than two conductive pads, and one pad on the substrate 110 may be bonded to one or more conductive pads, but this is not limited thereto. In addition, the light-emitting element (including a plurality of light-emitting diodes) of the present embodiment is disposed, so that the quantity of entire transferred light-emitting elements (for example, transferred from a growth substrate to the substrate 110) may be reduced, which may reduce the quantity of pads on the substrate and may improve process yield.

Furthermore, a method for manufacturing an electronic device 10 of the present embodiment may include the following steps.
Step 1: A first light-emitting diode 121 and a second light-emitting diode 122 are formed respectively on a growth substrate (not shown). The first light-emitting diode 121 includes a first p-type electrode 1211, a first p-type semiconductor layer 1212, a light-emitting layer 1213, a first n-type semiconductor layer 1214, and a first n-type electrode 1215. The second light-emitting diode 122 includes a second p-type electrode 1221, a second p-type semiconductor layer 1222, a light-emitting layer 1223, a second n-type semiconductor layer 1224, and a second n-type electrode 1225.
Step 2: A first insulation layer 123 is formed on the first light-emitting diode 121 and the second light-emitting diode 122, so that the first insulation layer 123 at least partially covers and/or surrounds the first light-emitting diode 121 and the second light-emitting diode 122. The first insulation layer 123 includes an opening 1231, an opening 1232, an opening 1233, and an opening 1234. The opening 1231 exposes the first n-type electrode 1215 of a portion of the first light-emitting diode 121, and the opening 1232 exposes the first p-type electrode 1211 of a portion of the first light-emitting diode 121. The opening 1233 exposes the second n-type electrode 1225 of a portion of the second light-emitting diode 122, and the opening 1234 exposes the second p-type electrode 1221 of a portion of the second light-emitting diode 122.
Step 3: An organic layer 124 is formed on the first insulation layer 123, so that the organic layer 124 at least partially covers the first insulation layer 123 and/or surrounds the first light-emitting diode 121 and the second light-emitting diode 122. The organic layer 124 includes a plurality of through holes 1241, 1242, 1243, and 1244. The through hole 1241 is in cooperation with the opening 1231 of the first insulation layer 123, to expose the first n-type electrode 1215 of the portion of the first light-emitting diode 121. The through hole 1242 is in cooperation with the opening 1232 of the first insulation layer 123, to expose the first p-type electrode 1211 of the portion of the first light-emitting diode 121. The through hole 1243 is in cooperation with the opening 1233 of the first insulation layer 123, to expose the second n-type electrode 1225 of the portion of the second light-emitting diode 122. The through hole 1244 is in cooperation with the opening 1234 of the first insulation layer 123, to expose the second p-type electrode 1221 of the portion of the second light-emitting diode 122.
Step 4: After the organic layer 124 is formed on the first insulation layer 123, a conductive layer 125 is formed on a portion of the organic layer 124 and in the through hole 1242 and the through hole 1243. The conductive layer 125 may be in contact with the first p-type electrode 1211 and the second n-type electrode 1225, or the conductive layer 125 may be electrically connected to the first p-type electrode 1211 of the first light-emitting diode 121 and the second n-type electrode 1225 of the second light-emitting diode 122.
Step 5: A second insulation layer 126 is formed on the organic layer 124 and the conductive layer 125, so that the second insulation layer 126 at least partially covers the organic layer 124 and the conductive layer 125. The second insulation layer 126 includes an opening 1261 and an opening 1262. The opening 1261 is in cooperation with the through hole 1241 of the organic layer 124 and the opening 1231 of the first insulation layer 123, to expose the first n-type electrode 1215 of the portion of the first light-emitting diode 121. The opening 1262 is in cooperation with the through hole 1244 of the organic layer 124 and the opening 1234 of the first insulation layer 123, to expose the second p-type electrode 1221 of the portion of the second light-emitting diode 122.
Step 6: A first conductive pad 127 is formed in the opening 1231 of the first insulation layer 123, a through hole 1241 of the organic layer 124, and an opening 1261 of the second insulation layer 126, and a second conductive pad 128 is formed in the opening 1234 of the first insulation layer 123, the through hole 1244 of the organic layer 124, and the opening 1262 of the second insulation layer 126. The first conductive pad 127 is electrically connected to the first n-type electrode 1215, and the second conductive pad 128 is electrically connected to the second p-type electrode 1221. Accordingly, the light-emitting element 120 of the present embodiment is manufactured.
Step 7: The completed light-emitting element 120 is transferred from a growth substrate to a substrate 110, so that the first conductive pad 127 of the light-emitting element 120 is electrically connected to the first pad 130 on the substrate 110, and the second conductive pad 128 of the light-emitting element 120 is electrically connected to the second pad 132 on the substrate 110. Next, the growth substrate is removed by laser heating, so that the light-emitting element 120 disposed on the substrate 110 is separated from the growth substrate. Accordingly, the electronic device 10 of the present embodiment is manufactured, as shown in FIG. 1A and FIG. 1B.

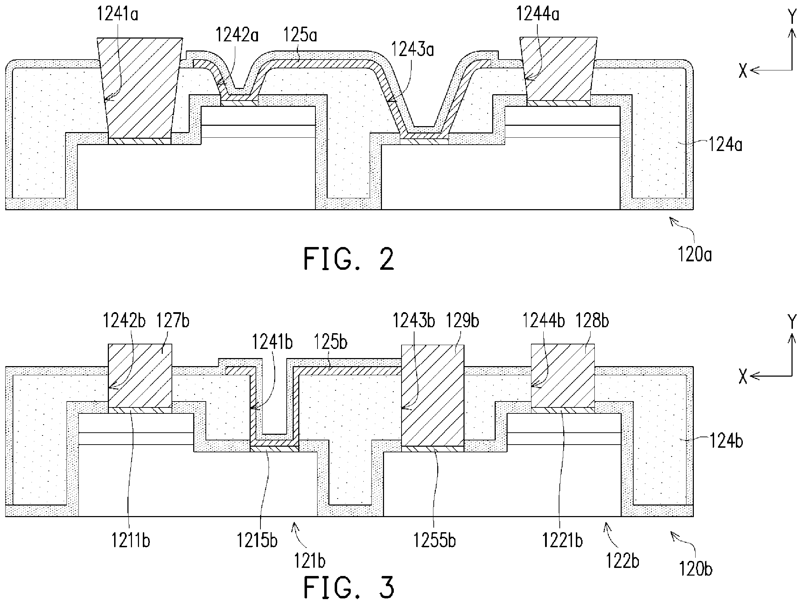

FIG. 2 is a schematic cross-sectional view of a light-emitting element according to a second embodiment of the disclosure. The light-emitting element 120a of the present embodiment and the light-emitting element 120 mainly lies in that a through hole 1241a, a through hole 1242a, a through hole 1243a, and a through hole 1244a of an organic layer 124a of the light-emitting element 120a of the present embodiment are all inverted trapezoid. In other words, both the through hole 1242a and the through hole 1243a have inclined sidewalls, so that a conductive layer 125a formed in the through hole 1242a and the through hole 1243a may be easily formed.

FIG. 3 is a schematic cross-sectional view of a light-emitting element according to a third embodiment of the disclosure. The light-emitting element 120b of the present embodiment and the light-emitting element 120 mainly lies in that, in the light-emitting element 120b of the present embodiment, the first light-emitting diode 121b and the second light-emitting diode 122b are electrically connected in parallel, and the light-emitting element 120b further includes a third conductive pad 129b.

Specifically, in the present embodiment, the through hole 1241b of the organic layer 124b exposes the first n-type electrode 1215b of a portion of the first light-emitting diode 121b, the through hole 1242b exposes the first p-type electrode 1211b of a portion of the first light-emitting diode 121b, the through hole 1243b exposes the second n-type electrode 1225b of a portion of the second light-emitting diode 122b, and the through hole 1244b exposes the second p-type electrode 1221b of a portion of the second light-emitting diode 122b. The conductive layer 125b is disposed on a side wall and a bottom of the through hole 1241b, and is disposed on the organic layer 124b between the through hole 1241b and the through hole 1243b, so that the conductive layer 125b is electrically connected to the first n-type electrode 1215b and the third conductive pad 129b, but is not in contact with and/or is electrically insulated from the first conductive pad 127b and the second conductive pad 128b. In addition, the first conductive pad 127b is disposed in the through hole 1242b of the organic layer 124b, so that the first conductive pad 127b is electrically connected to the first p-type electrode 1211b. The second conductive pad 128b is disposed in the through hole 1244b of the organic layer 124b, so that the second conductive pad 128b is electrically connected to the second p-type electrode 1221b. The third conductive pad 129b is disposed in the through hole 1243b of the organic layer 124b, so that the third conductive pad 129b is electrically connected to the second n-type electrode 1225b.

Therefore, the first light-emitting diode 121b may be electrically connected to the second light-emitting diode 122b through the conductive layer 125b and the third conductive pad 129b. That is, for the light-emitting element 120b of the present embodiment, the first n-type electrode 1215b of the first light-emitting diode 121b and the second n-type electrode 1225b of the second light-emitting diode 122b may be electrically connected in parallel by using the conductive layer 125b and the third conductive pad 129b. In addition, in the present embodiment, the light-emitting element 120b is in contact with the first pad 130 on the substrate 110 using the first conductive pad 127b, and is in contact with the second pad 132 on the substrate 110 using the second conductive pad 128b. In the present embodiment, the substrate 110 may include another pad (not shown), and the third conductive pad 129b may be electrically connected to the another pad, but this is not limited thereto.

Furthermore, in the present embodiment, since the first light-emitting diode 121b and the second light-emitting diode 122b are electrically connected in parallel, when one of the light-emitting diodes fails to emit light due to damage, there may be the other light-emitting diode available as an alternative.

It should be understood that the drawings of the foregoing embodiments are merely examples. In some embodiments, the first conductive pad 127b and the second conductive pad 128b of the light-emitting element 120b may be bonded to a same pad, that is, one pad on the substrate 110 may be connected to one or more conductive pads, but this is not limited thereto.

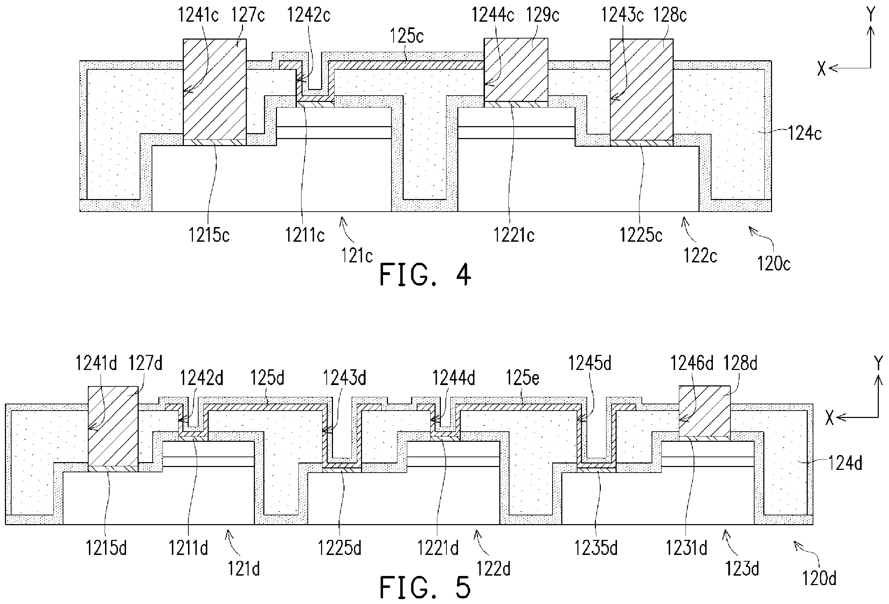

FIG. 4 is a schematic cross-sectional view of a light-emitting element according to a fourth embodiment of the disclosure. The light-emitting element 120c of the present embodiment and the light-emitting element 120 mainly lies in that, in the light-emitting element 120c of the present embodiment, the first light-emitting diode 121c and the second light-emitting diode 122c are electrically connected in parallel, and the light-emitting element 120c further includes a third conductive pad 129c.

Specifically, in the present embodiment, the through hole 1241c of the organic layer 124c exposes the first n-type electrode 1215c of a portion of the first light-emitting diode 121c, the through hole 1242c exposes the first p-type electrode 1211c of a portion of the first light-emitting diode 121c, the through hole 1243c exposes the second n-type electrode 1225c of a portion of the second light-emitting diode 122c, and the through hole 1244c exposes the second p-type electrode 1221c of a portion of the second light-emitting diode 122c. The conductive layer 125c is disposed on a side wall and a bottom of the through hole 1242c, and is disposed on the organic layer 124c between the through hole 1242c and the through hole 1244c, so that the conductive layer 125c is electrically connected to the first p-type electrode 1211c and the third conductive layer 129c, but is not in contact with and/or is electrically insulated from the first conductive pad 127c and the second conductive pad 128c. In addition, the first conductive pad 127c is disposed in the through hole 1241c of the organic layer 124c, so that the first conductive pad 127c is electrically connected to the first n-type electrode 1215c. The second conductive pad 128c is disposed in the through hole 1243c of the organic layer 124c, so that the second conductive pad 128c is electrically connected to the second n-type electrode 1225c. The third conductive pad 129c is disposed in the through hole 1244c of the organic layer 124c, so that the third conductive pad 129c is electrically connected to the second p-type electrode 1221c.

Therefore, the first light-emitting diode 121c may be electrically connected to the second light-emitting diode 122c through the conductive layer 125c and the third conductive pad 129c. That is, for the light-emitting element 120c of the present embodiment may be electrically connected to the first p-type electrode 1211c of the first light-emitting diode 121c and the second p-type electrode 1221c of the second light-emitting diode 122c in parallel by using the conductive layer 125c and the third conductive pad 129c. In addition, in the present embodiment, the light-emitting element 120c is in contact with the first pad 130 on the substrate 110 using the first conductive pad 127c, and is in contact with the second pad 132 on the substrate 110 using the second conductive pad 128c. In the present embodiment, the substrate 110 may include another pad (not shown), and the third conductive pad 129c may be electrically connected to the another pad, but this is not limited thereto.

Furthermore, in the present embodiment, since the first light-emitting diode 121c and the second light-emitting diode 122c are electrically connected in parallel, when one of the light-emitting diodes fails to emit light due to damage, there may be the other light-emitting diode available as an alternative.

FIG. 5 is a schematic cross-sectional view of a light-emitting element according to a fifth embodiment of the disclosure. The light-emitting element 120d of the present embodiment and the light-emitting element 120 mainly lies in that the light-emitting element 120d of the present embodiment further includes a third light-emitting diode 123d and a conductive layer 125e. An organic layer 124d further includes a through hole 1245d and a through hole 1246d.

Specifically, in the present embodiment, the third light-emitting diode 123d and the second light-emitting diode 122d are disposed adjacent to each other, so that the second light-emitting diode 122d is located between the first light-emitting diode 121d and the third light-emitting diode 123d, but the two may be disposed according to design requirements, which is not limited thereto.

A through hole 1241d of the organic layer 124d exposes a first n-type electrode 1215d of a portion of the first light-emitting diode 121d, a through hole 1242d exposes a first p-type electrode 1211d of a portion of the first light-emitting diode 121d, a through hole 1243d exposes a second n-type electrode 1225d of a portion of the second light-emitting diode 122d, a through hole 1244d exposes a second p-type electrode 1221d of a portion of the second light-emitting diode 122d, the through hole 1245d exposes a third n-type electrode 1235d of a portion of the third light-emitting diode 123d, and the through hole 1246d exposes a third p-type electrode 1231d of a portion of the third light-emitting diode 123d.

A conductive layer 125d is disposed on a side wall and a bottom of the through hole 1242d and the through hole 1243d, and is disposed on the organic layer 124d between the through hole 1242d and the through hole 1243d, so that the conductive layer 125d is electrically connected to the first p-type electrode 1211d and the second n-type electrode 1225d.

A conductive layer 125e is disposed on a side wall and a bottom of the through hole 1244d and the through hole 1245d, and is disposed on the organic layer 124d between the through hole 1244d and the through hole 1245d, so that the conductive layer 125e is electrically connected to the second p-type electrode 1221d and the third n-type electrode 1235d. In the present embodiment, the conductive layer 125d is not in contact with and/or is electrically insulated from the first conductive pad 127d, the conductive layer 125e is not in contact with and/or is electrically insulated from the second conductive pad 128d, and the conductive layer 125d is not in contact with and/or is electrically insulated from the conductive layer 125e. Therefore, the first light-emitting diode 121d may be electrically connected to the second light-emitting diode 122d through the conductive layer 125d, and the second light-emitting diode 122d may be electrically connected to the third light-emitting diode 123d through the conductive layer 125e. That is, for the light-emitting element 120d of the present embodiment, the first p-type electrode 1211d of the first light-emitting diode 121d and the second n-type electrode 1225d of the second light-emitting diode 122d may be electrically connected in series using the conductive layer 125d, and the second p-type electrode 1221d of the second light-emitting diode 122d and the third n-type electrode 1235d of the third light-emitting diode 123d are electrically connected in series by using the conductive layer 125e.

In addition, the first conductive pad 127d is disposed in the through hole 1241d of the organic layer 124d, so that the first conductive pad 127d is electrically connected to the first n-type electrode 1215d. The second conductive pad 128d is disposed in the through hole 1246d of the organic layer 124d, so that the second conductive pad 128d is electrically connected to the third p-type electrode 1231d. In the present embodiment, the light-emitting element 120d may be in contact with the first pad 130 on the substrate 110 using the first conductive pad 127d, and is in contact with the second pad 132 on the substrate 110 using the second conductive pad 128d.

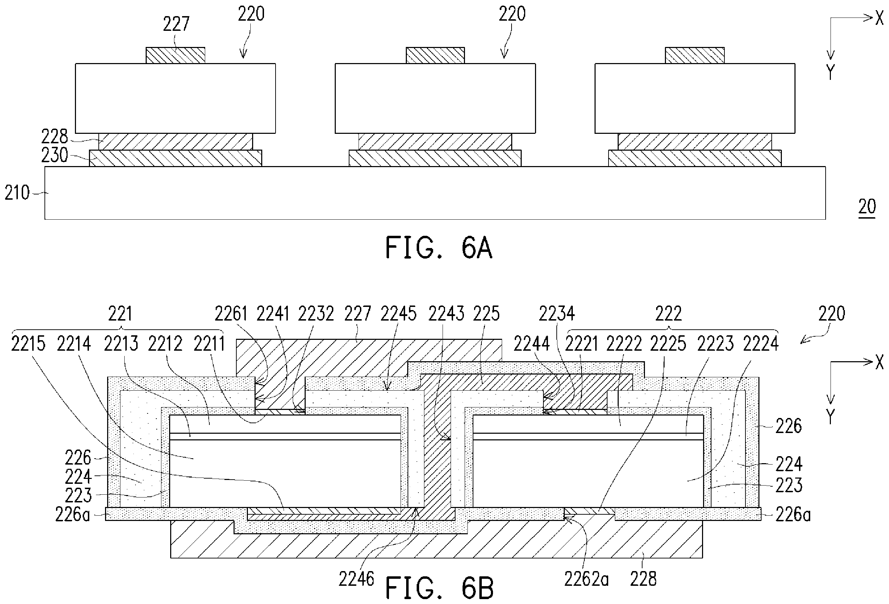

FIG. 6A is a schematic cross-sectional view of an electronic device according to a sixth embodiment of the disclosure. In order to make the drawings clear and for ease of description, several elements in a light-emitting element 220 are omitted in FIG. 6A. FIG. 6B is an enlarged schematic view of a light-emitting element in the electronic device of FIG. 6A. The light-emitting element 220 of the present embodiment and the light emitting unit 120 mainly lies in that the first conductive pad 227 and the second conductive pad 228 of the present embodiment are located on two opposite sides of the light-emitting element 220, respectively, and the light-emitting element 220 further includes a third insulation layer 226a.

Specifically, referring to FIG. 6A and FIG. 6B together, in the present embodiment, the first pad 230 is disposed on the substrate 210, and the light-emitting element 220 is disposed on the first pad 230, so that the light-emitting element 220 is electrically connected to the substrate 210 through the first pad 230. The first light-emitting diode 221 includes a first p-type electrode 2211, a first p-type semiconductor layer 2212, a light-emitting layer 2213, a first n-type semiconductor layer 2214, and a first n-type electrode 2215. The second light-emitting diode 222 includes a second p-type electrode 2221, a second p-type semiconductor layer 2222, a light-emitting layer 2223, a second n-type semiconductor layer 2224, and a second n-type electrode 2225.

The first insulation layer 223 includes an opening 2232 and an opening 2234. The opening 2232 exposes the first p-type electrode 2211 of a portion of the first light-emitting diode 221. The opening 2234 exposes the second p-type electrode 2221 of a portion of the second light-emitting diode 222.

The organic layer 224 includes at least two through holes 2241, 2243, and 2244. The through hole 2241 is in cooperation with the opening 2232 of the first insulation layer 223, to expose the first p-type electrode 2211 of the portion of the first light-emitting diode 221. The through hole 2244 is in cooperation with the opening 2234 of the first insulation layer 223, to expose the second p-type electrode 2221 of the portion of the second light-emitting diode 222. The through hole 2243 is in cooperation with the first surface 2245 and the second surface 2246 that face each other and that are of the organic layer 224. In the present embodiment, the organic layer 224 is disposed between the first light-emitting diode 221 and the second light-emitting diode 222, and is disposed between the first light-emitting diode 221 and the conductive layer 225, and is disposed between the second light-emitting diode 222 and the conductive layer 225.

The conductive layer 225 is disposed on a portion of the organic layer 224 and inside at least two through holes 2243 and 2244. The conductive layer 225 is disposed on a side wall and a bottom of the through hole 2244, on a side wall of the through hole 2243, on the organic layer 224 between the through hole 2244 and the through hole 2243, and between the first n-type electrode 2215 of the first light-emitting diode 221 and the third insulation layer 226a. The conductive layer 225 may be electrically connected to the first light-emitting diode 221 and the second light-emitting diode 222 through the through hole 2244 and the through hole 2243. In the present embodiment, the conductive layer 225 is electrically connected to the first n-type electrode 2215 of the first light-emitting diode 221 and the second p-type electrode 2221 of the second light-emitting diode 222. That is, the first light-emitting diode 121 and the second light-emitting diode 122 may be electrically connected in series, but this is not limited thereto.

The opening 2261 of the second insulation layer 226 is in cooperation with the through hole 2241 of the organic layer 224 and the opening 2232 of the first insulation layer 223, to expose the first p-type electrode 2211 of the portion of the first light-emitting diode 221.

The third insulation layer 226a is disposed between the first light-emitting diode 121 and the second conductive pad 228, between the second light-emitting diode 122 and the second conductive pad 228, and between the conductive layer 225 and the second conductive pad 228. The third insulation layer 226a covers the organic layer 224, the first n-type semiconductor layer 2214 and the first n-type electrode 2215 of the first light-emitting diode 121, the conductive layer 225, and the second n-type semiconductor layer 2224 of the second light-emitting diode 122. The third insulation layer 226a includes an opening 2262a. The opening 2262a exposes the second n-type electrode 2225 of a portion of the second light-emitting diode 222. In the present embodiment, the third insulation layer 226a may be made of silicon oxide, silicon nitride, silicon oxynitride, or a combination thereof, but this is not limited thereto.

The first conductive pad 227 is disposed in the opening 2232 of the first insulation layer 223, the through hole 2241 of the organic layer 224, and the opening 2261 of the second insulation layer 226, and is disposed on the second insulation layer 226. That is, the first conductive pad 227 is disposed on the first p-type electrode 2211 of the first light-emitting diode 221, and the first conductive pad 227 is electrically connected to the first p-type electrode 2211. The second conductive pad 228 is disposed in the opening 2262a of the third insulation layer 226a and on the third insulation layer 226a. That is, the second conductive pad 228 is disposed on the second n-type electrode 2225 of the second light-emitting diode 222, and the second conductive pad 228 is electrically connected to the second n-type electrode 2225. In the present embodiment, the conductive layer 225 is located between the first conductive pad 227 and the second conductive pad 228, and the conductive layer 225 is not in contact with and/or is electrically insulated from the first conductive pad 227 and the second conductive pad 228. In the present embodiment, the second n-type electrode 2225 may be electrically connected to the first pad 230 through the second conductive pad 228.

Based on the above, in the electronic device according to the embodiments of the disclosure, the light-emitting element may include two or more light-emitting diodes (for example, the first light-emitting diode and the second light-emitting diode). In addition, the organic layer may be disposed between the conductive layer and the light-emitting diode to reduce the probability of disconnection of the conductive layer. The light-emitting diodes may be surrounded and fixed together by the organic layer and electrically connected by the conductive layer. Accordingly, the electronic device including the light-emitting element may have relatively low power consumption.

## Claims

1. An electronic device (10), comprising:
a substrate (110, 210); and
at least one light-emitting element (120, 120a, 120b, 120c, 120d, 220) disposed on the substrate (110, 210) and comprising:
a first light-emitting diode (121, 121b, 121c, 121d, 221);
a second light-emitting diode (122, 122b, 122c, 122d, 222);
a conductive layer (125, 125b, 125c, 125d, 125e, 225); and
an organic layer (124, 124a, 124b, 124c, 124d, 224) disposed between the first light-emitting diode (121, 121b, 121c, 121d, 221) and the conductive layer (125, 125b, 125c, 125d, 125e, 225) and comprising at least two through holes (1241b, 1242, 1242a, 1242c, 1242d, 1243, 1243a, 1243b, 1243d, 1244c, 2243, 2244),
wherein the conductive layer (125, 125b, 125c, 125d, 125e, 225) is electrically connected to the first light-emitting diode (121, 121b, 121c, 121d, 221) and the second light-emitting diode (122, 122b, 122c, 122d, 222) through the at least two through holes (1241b, 1242, 1242a, 1242c, 1242d, 1243, 1243a, 1243b, 1243d, 1244c, 2243, 2244).

2. The electronic device according to claim 1, wherein the first light-emitting diode (121) comprises a first p-type electrode (1211) and a first n-type electrode (1215), the second light-emitting diode (122) comprises a second p-type electrode (1221) and a second n-type electrode (1225), and the conductive layer (125) is electrically connected to the first p-type electrode (1211) of the first light-emitting diode (121) and the second n-type electrode (1225) of the second light-emitting diode (122).

3. The electronic device according to claim 2, further comprising:
at least one first pad (130) and at least one second pad (132) respectively disposed on the substrate (110), wherein the at least one first pad (130) is electrically connected to the first n-type electrode (1215) of the first light-emitting diode (121), and the at least one second pad (132) is electrically connected to the second p-type electrode (1221) of the second light-emitting diode (122).

4. The electronic device according to claim 3, wherein the at least one light-emitting element (120) further comprises:
a first conductive pad (127) disposed on the first light-emitting diode (121); and
a second conductive pad (128) disposed on the second light-emitting diode (122), wherein the first n-type electrode (1215) is electrically connected to the at least one first pad (130) through the first conductive pad (127), and the second p-type electrode (1221) is electrically connected to the at least one second pad (132) through the second conductive pad (128).

5. The electronic device according to claim 1, wherein the first light-emitting diode (121b) comprises a first p-type electrode (1211b) and a first n-type electrode (1215b), the second light-emitting diode (122b) comprises a second p-type electrode (1221b) and a second n-type electrode (1225b), and the conductive layer (125b) is electrically connected to the first n-type electrode (1215b) of the first light-emitting diode (121b) and the second n-type electrode (1225b) of the second light-emitting diode (122b).

6. The electronic device according to claim 5, further comprising:
at least one first pad (130) and at least one second pad (132) respectively disposed on the substrate (110), wherein the at least one first pad (130) is electrically connected to the first p-type electrode (1211b) of the first light-emitting diode (121b), and the at least one second pad (132) is electrically connected to the second p-type electrode (1221b) of the second light-emitting diode (122b).

7. The electronic device according to claim 6, wherein the at least one light-emitting element further comprises:
a first conductive pad (127b) disposed on the first light-emitting diode (121b);
a second conductive pad (128b) disposed on the second light-emitting diode (122b); and
a third conductive pad (129b) disposed on the second light-emitting diode (122b), wherein the first p-type electrode (1211b) is electrically connected to the at least one first pad (130) through the first conductive pad (127b), the second p-type electrode (1221b) is electrically connected to the at least one second pad (132) through the second conductive pad (128b), and the conductive layer (125b) is electrically connected to the second n-type electrode (1225b) of the second light-emitting diode (122b) through the third conductive pad (129b).

8. The electronic device according to claim 1, wherein the first light-emitting diode (221) comprises a first p-type electrode (2211) and a first n-type electrode (2215), the second light-emitting diode (222) comprises a second p-type electrode (2221) and a second n-type electrode (2225), and the conductive layer (225) is electrically connected to the first n-type electrode (2215) of the first light-emitting diode (221) and the second p-type electrode (2221) of the second light-emitting diode (222).

9. The electronic device according to claim 8, further comprising:
at least one second pad (230) disposed on the substrate (210) and electrically connected to the second n-type electrode (2225) of the second light-emitting diode (222).

10. The electronic device according to claim 9, wherein the at least one light-emitting element (220) further comprises:
a first conductive pad disposed on the first light-emitting diode (221); and
a second conductive pad (228) disposed on the second light-emitting diode (222), wherein the second n-type electrode (2225) is electrically connected to the at least one second pad (230) through the second conductive pad (228).

11. The electronic device according to claim 1, wherein the at least one light-emitting element (120) is a flip-chip type light-emitting element.

12. A light-emitting element, comprising:
a first light-emitting diode (121);
a second light-emitting diode (122);
a conductive layer (125); and
an organic layer (124) disposed between the first light-emitting diode (121) and the conductive layer (125) and comprising at least two through holes (1242, 1243),
wherein the conductive layer (125) is electrically connected to the first light-emitting diode (121) and the second light-emitting diode (122) through the at least two through holes (1242, 1243).

13. The light-emitting element according to claim 12, wherein the first light-emitting diode (121) comprises a first p-type electrode (1211) and a first n-type electrode (1215), the second light-emitting diode (122) comprises a second p-type electrode (1221) and a second n-type electrode (1225), and the conductive layer (125) is electrically connected to the first p-type electrode (1211) of the first light-emitting diode (121) and the second n-type electrode (1225) of the second light-emitting diode (122).

14. The light-emitting element according to claim 12, wherein a maximum thickness (HI) of the organic layer (124) is greater than a maximum height (H2) of the first light-emitting diode (121).

15. The light-emitting element according to claim 12, wherein a minimum spacing (D) between the first light-emitting diode (121) and the second light-emitting diode (122) ranges from 1.5 µm to 10 µm.
